# FASCICULE DE BREVET EUROPEEN

(11) **EP 0 688 889 B1**
(45) Date de publication et mention de la délivrance du brevet: **30.08.2000**
(21) Numéro de dépôt: 95401460.1
(22) Date de dépôt: 20.06.1995
(51) Int. Cl.: C23C 28/04, C23C 16/02, C10G 9/20, B01J 19/00

(54) **Méthode de passivation de pièces métalliques en super-alliage à base de nickel et de fer**
Verfahren zur Passivierung von Werkstücken aus Eisen-Nickelbasis-Superlegierungen
Method for passivating nickel and iron based superalloy parts

(30) Priorité: 24.06.1994 FR 9407907
(43) Date de publication de la demande: 27.12.1995
(73) Titulaire: INSTITUT FRANCAIS DU PETROLE, 92502 Rueil-Malmaison (FR)
(72) Inventeur: Broutin, Paul, F-69630 Chapanost (FR); Nisio, Pascal, F-69003 Lyon (FR); Ropital, François, 92500 Rueil Malmaison (FR)

(56) Documents cités:
- EP-A- 0 446 988
- EP-A- 0 540 084
- FR-A- 2 662 704
- PATENT ABSTRACTS OF JAPAN vol. 014 no. 299 (C-0733) ,27 Juin 1990 & JP-A-02 097659 (SUMITOMO ELECTRIC IND LTD;OTHERS: 01) 10 Avril 1990,
- PATENT ABSTRACTS OF JAPAN vol. 014 no. 115 (C-0696) ,5 Mars 1990 & JP-A-01 316449 (RAIMUZU:KK) 21 Décembre 1989,
- PATENT ABSTRACTS OF JAPAN vol. 010 no. 023 (C-325) ,29 Janvier 1986 & JP-A-60 177179 (TOSHIBA KK) 11 Septembre 1985,
- PATENT ABSTRACTS OF JAPAN vol. 016 no. 265 (C-0951) ,16 Juin 1992 & JP-A-04 063279 (CHIYODA CORP) 28 Février 1992,

## Description

La présente invention concerne une méthode de passivation de pièces métalliques en superalliage à base de nickel et de fer. Cette passivation concerne la surface de ces pièces métalliques. Elle concerne également le produit métallique comportant au moins une partie de sa surface ayant été traitée suivant la méthode de passivation de la présente demande. La méthode de la présente invention permet d'obtenir des pièces métalliques ayant, à haute température, une meilleure résistance aux atmosphères oxydantes, et un comportement vis-à-vis des hydrocarbures tel que la carburation et le cokage sont largement diminués par rapport aux pièces non traitées.

La présente méthode permet en particulier de limiter la corrosion des surfaces externes des pièces par oxydation lors d'un contact de ces surfaces avec une atmosphère oxydante et également de limiter la cémentation ainsi que le cokage dans le cas d'un contact avec des hydrocarbures à haute température. Cette méthode s'applique très avantageusement au traitement de la surface des réacteurs ou des fours et en particulier des fours tubulaires utilisés dans l'industrie. Au sens de la présente description, les termes carburation et cémentation sont considérés comme équivalents.

Plus particulièrement, cette méthode permet de limiter le cokage dans les réacteurs de craquage thermique d'hydrocarbures et dans les fours tubulaires chauffant des hydrocarbures à haute température et par exemple à une température supérieure à 350 °C. Il est en effet bien connu des hommes du métier que c'est à partir de cette température qu'apparaissent les réactions de cokage à la paroi desdits réacteurs et/ou tubes de fours. La méthode de la présente invention s'applique plus particulièrement aux dispositifs pour la mise en oeuvre des procédés de vapocraquage, de pyrolyse en l'absence de diluant ou en présence de diluant autre que de la vapeur d'eau tel que par exemple en présence d'hydrogène, d'hydrocarbures ou de coupes d'hydrocarbures.

La méthode de la présente invention s'applique également aux dispositifs pour la mise en oeuvre des procédés de déshydrogénation catalytique, de vaporéformage catalytique et de viscoréduction d'hydrocarbures ou de coupes d'hydrocarbures.

De très nombreux documents décrivent la réaction de formation de coke dans diverses réactions mettant en contact des hydrocarbures avec des parois à une température élevée. Ce phénomène de cokage est en particulier largement décrit et étudié dans le cadre du craquage thermique d'hydrocarbures. Comme article de fond on peut citer en particulier celui écrit par le professeur FROMENT et paru en 1990 dans le périodique Review of Chemical Engineering, volume 6, numéro 4, pages 292 à 328, sous le titre "Coke formation in the thermal cracking of Hydrocarbon". On peut également citer un article plus récent paru dans la Revue de l'INSTITUT FRANÇAIS DU PÉTROLE en 1992 sous la plume de MM. BILLAUD, BROUTIN, BUSSON, GUERET et WEILL, volume 47, numéro 4, pages 537 à 549, sous le titre "Coke Formation during Hydrocarbons Pyrolysis" pour ce qui est de la première partie et dans cette même revue en 1993, volume 48, numéro 2, pages 115 à 125, sous le même titre, pour la deuxième partie.

Pour résumer les observations décrites dans l'art antérieur, on peut dire que la formation de coke lors du craquage thermique d'hydrocarbures est un phénomène complexe mettant en jeu différents mécanismes dont l'un au moins met en jeu des réactions catalysées par la présence d'oxydes d'éléments métalliques tels que le nickel, le fer ou le cobalt à la paroi des dispositifs utilisés pour la mise en oeuvre des dits procédés. Ces éléments métalliques sont en général contenus en quantité importante dans les superalliages réfractaires utilisés du fait notamment des niveaux thermiques rencontrés au niveau de la paroi de ces dispositifs. Ce mécanisme catalytique est très prépondérant : des observations ont montré que si ce mécanisme était inhibé, il était possible dans le cas du vapocraquage d'accroître par un facteur d'au moins environ 3 la durée de cycle entre 2 arrêts pour décokage des fours nécessaires pour la mise en oeuvre de ce procédé.

Un certain nombre de documents font état de méthodes permettant d'inhiber la formation de coke catalytique ; on peut en particulier citer le brevet US-A-5 208 069 qui décrit une méthode de passivation de la surface métallique des tubes du réacteur entrant en contact avec des hydrocarbures par décomposition in-situ (c'est-à-dire dans l'appareil définitivement assemblé) d'un dérivé organométallique non oxygéné du silicium dans des conditions de formation d'une fine couche de matière céramique sur la surface de ces tubes. Cette méthode, dans laquelle le dépôt est effectué à pression atmosphérique ou en légère dépression, ne conduit généralement pas à l'obtention d'un dépôt relativement uniforme sur toute la longueur des tubes car la vitesse de croissance du dépôt n'est pas uniforme tout au long du tube et donc l'épaisseur, voire la qualité du dépôt, varie le long du tube. Ces variations entraînent un risque d'obtention de zones à fortes épaisseurs et donc de faible adhérence et/ou de zones dans lesquelles le dépôt de carbure de silicium est de mauvaise qualité et donc également de faible adhérence. Le niveau de pression auquel est (selon les exemples de ce brevet) opéré le dépôt en phase vapeur d'un dérivé organométallique du silicium est beaucoup trop important, ce qui ne permet pas d'avoir un dépôt homogène, car les distances de diffusion gazeuse sont beaucoup moins importantes que sous vide, c'est-à-dire par exemple à une pression inférieure à 10⁺⁴ Pascals. Par ailleurs, le carbure de silicium déposé est un composé de faible coefficient de dilatation alors que le superalliage employé a habituellement un coefficient de dilatation bien plus élevé, ce qui entraîne au cours du temps et des cycles de chauffage et de refroidissement un risque non négligeable de perte d'étanchéité, au moins en certains points, du revêtement de carbure de silicium et, par voie de conséquence, le contact entre les hydrocarbures et le superalliage, qui conduit à un accroissement de la vitesse de cokage de l'appareillage.

Il est également décrit dans le brevet US-A-5 242 574 une méthode de passivation des parois d'un réacteur formées à partir d'un superalliage à base de nickel et de fer ayant une forte teneur en aluminium (de 4 à 6 % en poids). Cette méthode de passivation consiste en la formation d'une couche d'oxyde métallique par préoxydation de la surface de l'alliage, ce qui entraîne la formation d'oxydes des métaux formant l'alliage. Cette passivation peut s'expliquer par le fait que la présence d'aluminium dans la matrice est bénéfique, car elle rend possible la génération par simple oxydation partielle sélective (dans les conditions de pression partielle en oxygène et de température mentionnées dans ce brevet) d'une couche superficielle d'alumine stable. Cette méthode ne permet généralement pas d'obtenir une couche uniforme ni dans sa composition, ni en ce qui concernent ses autres caractéristiques physiques. En outre, cette méthode de passivation ne s'applique facilement que dans le cas de superalliage à forte teneur en aluminium.

Par ailleurs, lors de l'utilisation d'alliages à forte teneur en aluminium, il y a le plus souvent formation d'une phase intermétallique γ' de composition Ni₃Al. Cette phase intermétallique est formée lors de l'utilisation à haute température, ce qui fragilise ce type de matériau : on observe un vieillissement du matériau dont la résistance au fluage diminue dans le temps. Ce phénomène conduit à ce que la température maximale d'utilisation de ce type de matériau soit de 100 °C inférieure à celle des superalliages à base nickel et de fer ne contenant de l' aluminium qu' en faible quantité, voire en très faible quantité, par exemple moins de 0,5 % en poids.

En outre, la présence d'aluminium dans la matrice peut conduire, lors des opérations de soudage, à la précipitation de la phase intermétallique dans les joints de grain, ce qui est défavorable à une bonne tenue mécanique (apparition de fissures, voire rupture). Les opérations de soudure pour ce type de matériau sont délicates comme pour tous les superalliages à base de nickel dont la teneur en aluminium est supérieure à environ 3 %, ces matériaux étant considérés comme difficilement soudables (d'après E. BRADLEY "Welding of Superalloys" Superalloys-a technical guide, 1988, Chapitre 13, pages 197 à 220).

Par ailleurs, la présence d'aluminium dans la matrice rend très difficile l'adhérence des revêtements au matériau. Les revêtements obtenus par dépôt chimique en phase vapeur (en abrégé CVD, des initiales anglo-saxonnes Chemical Vapor Deposition) (par exemple ceux décrits dans le brevet US-A-5 242 574) sur ce type de matériau sont peu adhérents et peu résistants notamment au cyclage thermique.

La présente invention propose une méthode de passivation de surface métallique en superalliage contenant peu ou pas d'aluminium permettant de pallier au moins en partie les inconvénients des méthodes de l'art antérieur et d'obtenir un revêtement résistant bien aux cyclages thermiques, ayant une bonne adhérence et une bonne homogénéité. La qualité du revêtement obtenu selon la méthode de l'invention peut être appréciée, comme cela sera montré par les exemples illustrant la présente demande de brevet, par des tests d'oxydation et/ou de cokage de surfaces métalliques ayant subi un traitement de passivation selon l'art antérieur et de surfaces métalliques ayant subi un traitement de passivation selon l'invention.

Dans sa forme la plus générale, l'invention concerne une méthode de revêtement d'au moins la paroi interne des tubes de four de vapocraquage d'hydrocrabures, constituée en superalliage à base de nickel et de fer contenant moins de 3 %, de préférence moins de 1 % et le plus souvent moins de 0,5 %, en poids d'aluminium, dans laquelle, pour réaliser la passivation de ladite paroi et/ou inhiber sur celle-ci la formation de coke catalytique, on revêt successivement ladite paroi par au moins une couche intermédiaire et une couche externe, ladite couche externe résultant du dépôt chimique en phase vapeur d'au moins un composé du silicium et ladite ou lesdites couches intermédiaires, déposées entre la surface du superalliage et la couche externe, résultant du dépôt chimique en phase vapeur d'au moins un composé d'un métal ou d'un métalloïde de la classification périodique des éléments et de préférence d'un composé du groupe 4 de cette classification, tel que par exemple le titane ou le zirconium, de préférence le titane, ladite ou lesdites couches intermédiaires étant choisies de manière que les coefficients de dilatation du superalliage et des couches successives aillent en décroissant depuis la valeur de celui du superalliage jusqu'à la valeur du coefficient de dilatation de la couche externe, ladite méthode étant en outre telle que l'on effectue les opérations de revêtement sous une pression de 1 000 à 10 000 Pascals.

La (ou les) couche(s) intermédiaire(s) a (ont) la fonction d'améliorer l'adhérence et la résistance aux chocs thermiques de l'ensemble du revêtement formé et de limiter les interdiffusions entre le superalliage et la couche externe. De plus, il est particulièrement important que les couches successives présentent les épaisseurs les plus uniformes possibles. C'est le résultat que la méthode de revêtement de l'invention permet d'obtenir.

Habituellement, le superalliage que l'on utilise a un coefficient de dilatation d'environ 10x10⁻⁶ à environ 25x10⁻⁶ par degré Kelvin (K⁻¹) et la couche externe formée à partir d'un composé de silicium a un coefficient de dilatation, strictement inférieur à celui du superalliage, d'environ 2x10⁻⁶ à environ 10x10⁻⁶ K⁻¹. La ou les couches intermédiaires ont habituellement un coefficient de dilatation compris entre 4x10⁻⁶ et 12x10⁻⁶ K⁻¹, toujours plus faible que celui du superalliage et toujours plus élevé que celui de la couche externe.

Dans une forme particulière de mise en oeuvre de l'invention le superalliage sera revêtu d'une seule couche intermédiaire entre la couche externe et sa surface.

Les couches de revêtement intermédiaires obtenues par dépôt chimique en phase vapeur sont soit de composition stoechiométrique, soit sont des solutions solides. Habituellement, ces composés stoechiométriques sont choisis dans le groupe formé par le carbure de titane TiC, le nitrure de titane TiN, le nitrure d'aluminium. Habituellement, les solutions solides sont choisies dans le groupe formé par les nitrures de formule générale TiᵤAlᵥN_{w} dans laquelle u, v et w sont des nombres positifs u étant le plus souvent un nombre compris entre environ 0,4 et environ 0,62, et v et w, identiques ou différents, des nombres compris entre environ 0 et environ 1, et les carbo-nitrures du titane de formule générale TiₓC_{y}N_{z} dans laquelle x, y et z sont des nombres positifs, x étant le plus souvent un nombre compris entre environ 0,35 et environ 0,55 et y et z, identiques ou différents, des nombres compris entre environ 0 et environ 1.

Dans une forme de réalisation particulière de la présente invention, on utilise un superalliage comprenant dans sa composition au moins 0,1 % en poids de carbone et la première couche de revêtement obtenu par dépôt chimique en phase vapeur, qui est directement en contact avec le superalliage, comprend au moins un composé stoechiométrique ou au moins une solution solide choisie dans le groupe formé par TiC et TiₓC_{y}N_{z}, x, y et z ayant la définition donnée ci-devant.

Dans une forme particulière de réalisation de l'invention, la couche externe qui est en contact avec l'atmosphère corrosive comprend au moins un composé stoechiométrique ou au moins une solution solide formée à partir du système Si-AI-O-N-C. Le terme "système" est un terme employé couramment par les hommes du métier dans le cadre des dépôts chimiques en phase vapeur. Ce terme "système", au sens de la présente description, représente l'ensemble des composés stoechiométriques ou des solutions solides formées à partir des éléments du système.

Dans une autre forme de réalisation de l'invention, la couche externe qui est en contact avec l'atmosphère corrosive comprend au moins un composé stoechiométrique choisi dans le groupe formé par le carbure de silicium de formule SiC et le nitrure de silicium de formule Si₃N₄. On peut aussi avoir une couche externe comprenant un mélage de ces deux composés.

Bien que les revêtements obtenus par dépôt chimique en phase vapeur puissent être réalisés selon les techniques classiques bien connues de l'homme du métier, il est souvent préférable, dans le but d'obtenir des revêtements trés adhérents, d'excellente homogénéité et ayant une bonne résistance aux cyclages thermiques, d'effectuer le dépôt chimique en phase vapeur à une température supérieure ou égale à environ 800 °C et le plus souvent d'environ 900 °C à environ 1100 °C. Ce dépôt est habituellement effectué sous une pression inférieure à la pression atmosphérique, souvent sous une pression d'environ 100 à environ 90 000 Pascals et de préférence d'environ 1 000 à 10 000 Pascals. Le flux molaire (au sein du réacteur de dépôt) du mélange gazeux employé pour effectuer le dépôt chimique en phase vapeur est habituellement d'environ 1x10⁻⁶ mole par centimètre carré et par seconde (molexcm⁻²xs⁻¹) à environ 1x10⁻² molexcm⁻²xs⁻¹. Dans le cas d'un revêtement de carbure de titane le rapport atomique C/Ti dans la phase gazeuse est habituellement d'environ 0 : 1 à environ 150 : 1 et le plus souvent d'environ 0 : 1 à environ 50 : 1. En l'absence de composé contenant du carbone dans la phase gazeuse, celui-ci provient du superalliage.

La méthode de passivation de surface métallique de la présente invention est particulièrement bien adaptée pour la réalisation d'un revêtement protecteur de la face interne (et éventuellement de la face interne et de la face externe) des tubes des fours de vapocraquage d'hydrocarbures. Ce ou ces revêtements peuvent être réalisés in-situ après assemblage du faisceau de tubes lors d'une première étape avant le fonctionnement du four pour le vapocraquage ou ex-situ avant l'assemblage du faisceau de tubes dans un four de traitement pour le dépôt chimique en phase vapeur. Dans le cas du traitement ex-situ, le revêtement peut être réalisé élément par élément ou série d'éléments par série d'éléments.

Le dépôt chimique en phase vapeur est une technique bien connue de l'homme du métier et ne sera pas détaillé dans le cadre de la présente description. A titre d'exemple, le dépôt peut être effectué en utilisant, dans le cas de formation d'un revêtement à base de silicium, du silane, des alkylsilanes, des aminoalkylsilanes, des haloalkylsilanes, des halosilanes ou des silazanes. On peut par exemple employer des chloroalkylsilanes ou des chlorosilanes. Dans le cas d'un revêtement de carbure de silicium, le dépôt CVD peut par exemple être effectué par décomposition d'un silane ou par réduction, par exemple par de l'hydrogène, d'un chloroalkylsilane tel que par exemple le trichlorométhylsilane. Dans le cas du revêtement à base de titane, on peut employer les mêmes types de composés et par exemple des halogénures de titane et en particulier le tétrachlorure de titane. Lorsqu'on emploie un ou des halogénures de titane pour effectuer un dépôt de carbure de titane, la réduction de cet ou de ces halogénures peut être faite par un composé réducteur comme par exemple l'hydrogène. Les dépôts CVD sont habituellement effectués en présence d'hydrogène dans des conditions telles que le rapport atomique H/métal dans la phase gazeuse soit d'environ 5 : 1 à environ 300 : 1 et le plus souvent d'environ 10 : 1 à environ 50 : 1.

Habituellement chaque couche de revêtement a une épaisseur d'environ 0,1x10⁻⁶ mètre (m) à environ 30x10⁻⁶m. Souvent la ou les couches intermédiaires ont une épaisseur inférieure à celle de la couche externe. Par exemple dans le cas d'un revêtement comprenant deux couches, la couche intermédiaire aura une épaisseur d'environ 0,15x10⁻⁶ m à environ 5x10⁻⁶ m et la couche externe une épaisseur d'environ 1x10⁻⁶ m à environ 30x10⁻⁶ m et le plus souvent d'environ 6x10⁻⁶ m à environ 25x10⁻⁶ m.

On emploie le plus souvent un superalliage comprenant en poids de 0,2 à 0,6 % de carbone, de 0,5 à 2 % de manganèse, de 0,5 à 2 % de silicium, de 30 à 40 % de nickel et de 20 à 30 % de chrome ainsi qu'éventuellement d'autres métaux tels que par exemple du niobium, du titane ou du zirconium et le complément à 100 % en poids étant du fer. Les tests présentés dans les exemples qui suivent pour illustrer l'invention ont été effectués sur des tubes en Manaurite XM qui est un superalliage comprenant en poids de 33 à 38 % de nickel, de 23 à 28 % de chrome, de 1 à 2 % de silicium, de 1 à 1,5 % de manganèse et de 0,3 à 0,6 % de carbone et le complément à 100 % en poids étant du fer.

La présente invention concerne également un produit comprenant un superalliage à base de nickel et de fer contenant moins de 3 % en poids d'aluminium, de préférence moins de 1 % en poids d'aluminium et le plus souvent moins de 0,5 % en poids d'aluminium, et comportant un revêtement de passivation obtenu selon la méthode décrite ci-devant.

L'exemple suivant illustre l'invention et ses avantages par rapport à la technique selon l'art antérieur et en particulier selon celle décrite dans le brevet européen EP-B-476 027.

Le tube A est réalisé en Manaurite XM et sert de comparaison. Le tube B est réalisé en Manaurite XM revêtu de carbure de titane seul et sert également de comparaison. Le tube C est en Manaurite XM revêtu d'une première couche de carbure de titane et d'une couche externe de carbure de silicium selon l'invention. Enfin, le tube D est réalisé en Manaurite XM revêtu de carbure de silicium seul et sert de comparaison.

Des essais de vapocraquage de naphta ont été réalisés en présence de vapeur d'eau à une température de peau en sortie du tube de pyrolyse de 1 048 °C sur une installation pilote équipée successivement de quatre tubes de même dimension ayant des compositions différentes telles que décrites ci-devant et dont les revêtements sont réalisés comme décrits ci-après. Au cours de ces essais, les tubes étaient chauffés par des fumées de combustion. Sur l'installation pilote, la trempe est effectuée à 500 °C de façon indirecte dans un échangeur type TLX en ligne.

Le tube A non revêtu a un coefficient de dilatation de 19,1x10⁻⁶ °K⁻¹.

Le tube B comporte un revêtement en carbure de titane d'une épaisseur de 5x10⁻⁶m obtenu comme suit. Le dépôt CVD est réalisé dans un réacteur à parois chaudes. La chambre de dépôt est en graphite. Elle est chauffée à 1 000 °C par des résistances électriques, sous atmosphère réductrice. Le mélange gazeux est injecté dans la partie supérieure du four et chaque gaz est dosé par des débitmètres massiques. Le tétrachlorure de titane, qui est un composé liquide dans les conditions standard de pression et de température, est préalablement chauffé pour pouvoir être dosé à l'état de vapeur. Les divers gaz sont mélangés préalablement à leur injection dans le four de dépôt. Après réaction sur les substrats dans la chambre de dépôt, les gaz produits et résiduels sont évacués par pompage à l'aide d'une pompe adaptée à leur caractère corrosif. Le dépôt est effectué par introduction d'un flux gazeux pendant 10 heures sous une pression de 4 kilopascals. Le flux est composé de TiCl₄ introduit à la vitesse de 3,7x10⁻⁷ molexcm⁻²xs⁻¹, de méthane CH₄ introduit à la vitesse de 2,5x10⁻⁶ molexcm⁻²xs⁻¹ et d'hydrogène H₂ introduit à la vitesse de 1,5x10⁻⁵ molexcm⁻²xs⁻¹. Le dépôt de carbure de titane a un coefficient de dilatation de 7x10⁻⁶ °K⁻¹.

Le tube C comporte un revêtement en carbure de titane d'une épaisseur de 2x10⁻⁶m obtenu comme comme ci-devant mais la durée du dépôt est de 4 heures. A la suite du dépôt du carbure de titane, on dépose une couche de carbure de silicium d'une épaisseur de 20x10⁻⁶m en utilisant le même four et en maintenant une température de 930°C. Le dépôt est effectué par introduction d'un flux gazeux pendant 40 heures sous une pression de 4 kilopascals. Le flux est composé de trichlorométhylsilane SiCH₃Cl₃ introduit à la vitesse de 4x10⁻⁷ molexcm⁻²xs⁻¹ et d'hydrogène H₂ introduit à la vitesse de 8x10⁻⁶ molexcm⁻²xs⁻¹. Le dépôt de carbure de silicium a un coefficient de dilatation de 4x10⁻⁶ °K⁻¹.

Le tube D comporte un revêtement en carbure de silicium d'une épaisseur de 20x10⁻⁶m obtenu comme ci-devant.

Le tableau ci-après donne les résultats obtenus et donne également les caractéristiques de la charge craquée.

**TABLEAU**

| | TUBE A | TUBE B | TUBE C | TUBE D |
|---|---|---|---|---|
| DIMENSIONS | | | | |
| Diamètre interne (mm) | 30 | 30 | 30 | 30 |
| Longueur (m) | 10 | 10 | 10 | 10 |

| CONDITIONS OPÉRATOIRES | | | | |
|---|---|---|---|---|
| Débit naphta (Kg/h) | 80 | 80 | 80 | 80 |
| Débit vapeur (Kg/h) | 40 | 40 | 40 | 40 |

| TEMPERATURES | | | | |
|---|---|---|---|---|
| Entrée du tube (°C) | 600 | 600 | 600 | 600 |
| Sortie du tube (°C) | 933 | 933 | 933 | 933 |

| PRESSIONS (absolue) | | | | |
|---|---|---|---|---|
| Sortie (MPa) | 0,155 | 0,155 | 0,155 | 0,155 |
| TEMPS DE SÉJOUR (ms) | 130 | 130 | 130 | 130 |

| CARACTÉRISTIQUES DU NAPHTA | | | | |
|---|---|---|---|---|
| Densité | | | 0,705 | |
| Distillation ASTM | | | | |
| Point Initial (°C) | | | 36 | |
| Point final (°C) | | | 193 | |

| COMPOSITION DU NAPHTA (% POIDS) | | | | |
|---|---|---|---|---|
| % N paraffines | | | 43,27 | |
| % Isoparaffines | | | 36,81 | |
| % Naphténiques | | | 14,97 | |
| % Aromatiques | | | 4,95 | |
| Température de peau en sortie | 1048 | 1048 | 1048 | 1048 |
| de tube au début du test (°C) | | | | |
| Vitesse de cokage en sortie du tube | 50 | 23 | 4 | 39 |
| (gxh⁻¹x m⁻²) | | | | |

Après démontage de chaque tube, une inspection visuelle montre que le revêtement du tube D formé de carbure de silicium seul est fissuré. Les revêtements des tubes B et C sont intacts. On constate que la vitesse de cokage est très largement inférieure dans le cas de l'utilisation de tubes comportant un revêtement en carbure par rapport au tube non revêtu et que cette vitesse de cokage est de beaucoup la plus faible dans le cas d'un tube revêtu selon la méthode de l'invention.

## Revendications

1. Méthode de revêtement d'au moins la paroi interne des tubes de fours de vapocraquage d'hydrocarbures, constituée en superalliage à base de nickel et de fer contenant moins de 3 % en poids d'aluminium et ayant un coefficient de dilatation d'environ 10x10⁻⁶ à environ 25x10⁻⁶ °K⁻¹, dans laquelle, pour réaliser la passivation de ladite paroi et/ou inhiber sur celle-ci la formation de coke catalytique, on revêt successivement ladite paroi
- par au moins une couche intermédiaire formée d'un composé choisi dans le groupe formé par le carbure de titane TiC, le nitrure de titane TiN, le nitrure d'aluminium, les nitrures de formule générale TiᵤAIᵥN_{w} dans laquelle u, v et w sont des nombres positifs, et les carbo-nitrures du titane de formule générale TiₓC_{y}N_{z} dans laquelle x, y et z sont des nombres positifs, et ayant un coefficient de dilatation d'environ 4x10⁻⁶ à environ 12x10⁻⁶ °K⁻¹, ladite couche (ou lesdites) couche(s) intermédiaire(s) ayant une épaisseur d'environ 0,1x10⁻⁶ à environ 30x10⁻⁶ m et résultant du dépôt chimique en phase vapeur d'au moins un composé d'un métal ou d'un métalloïde approprié, à une température supérieure ou égale à environ 800 °C et sous un flux molaire d'environ 10x10⁻⁶ à environ 10⁻² mole par cm² et par seconde,
- et par une couche externe formée d'au moins un composé de type stoechiométrique ou formé par au moins une solution solide formée à partir du système Si-Al-O-N-C et ayant un coefficient de dilatation d'environ 4x10⁻⁶ à environ 10x10⁻⁶ °K⁻¹, ladite couche externe ayant une épaisseur d'environ 0,1x10⁻⁶ à environ 30x10⁻⁶ m et résultant du dépôt chimique en phase vapeur d'au moins un composé du silicium, à une température supérieure ou égale à environ 800 °C et sous un flux molaire d'environ 10x10⁻⁶ à environ 10⁻² mole par cm² et par seconde,
ladite méthode étant en outre telle que, pour obtenir des couches d'épaisseurs sensiblement uniformes, on effectue les opérations de revêtement sous une pression de 1 000 à 10 000 Pascals.

2. Méthode selon la revendication 1 dans laquelle les couches intermédiaires obtenues par dépôt chimique en phase vapeur sont soit de composition stoechiométrique, soit des solutions solides.

3. Méthode selon l'une des revendications 1 et 2 dans laquelle on revêt un superalliage comprenant dans sa composition au moins 0,1 % en poids de carbone et la première couche de revêtement obtenue par dépôt chimique en phase vapeur directement sur le superalliage comprend au moins un composé stoechiométrique ou au moins une solution solide choisie dans le groupe formé par TiC et TiₓC_{y}N_{z}.

4. Méthode selon l'une des revendications 1 à 3 dans laquelle la couche externe du revêtement est à base de carbure de silicium, de nitrure de silicium ou de leur mélange.

5. Méthode selon l'une des revendications 1 à 4, dans laquelle on revêt ladite paroi interne par au moins une couche intermédiaire de carbure de titane TiC, puis par une couche de carbure de silicium SiC.

6. Méthode selon l'une des revendications 1 à 5, caractérisée en ce qu'elle est réalisée ex-situ avant assemblage du faisceau de tubes dans le four de vapocraquage.

7. Méthode selon l'une des revendications 1 à 5, caractérisée en ce qu'elle est réalisée in-situ après assemblage du faisceau de tubes dans le four de vapocraquage.

8. Un tube de four de vapocraquage dont la paroi interne est constituée en superalliage à base de nickel et de fer contenant moins de 3 % en poids d'aluminium et comporte un revêtement de passivation et/ou d'inhibition de la formation de coke catalytique, obtenu par une méthode selon l'une des revendications 1 à 7.

9. Un tube selon la revendication 8 dont la paroi interne est revêtue par une couche intermédiaire de carbure de titane TiC et par une couche de carbure de silicium SiC.

## Patentansprüche

1. Verfahren zum Überziehen wenigstens der Innenwand der Rohre von Dampfcracköfen für Kohlenwasserstoffe, bestehend aus einer Superlegierung auf der Basis von Nickel und Eisen, die weniger als 3 Gew.-% an Aluminum enthält und über einen Ausdehnungskoeffizienten von etwa 10 x 10⁻⁶ bis etwa 25 x 10⁻⁶ °K⁻¹ verfügt, bei der, zur Realisierung der Passivierung dieser Wand und/oder zur Inhibierung der Bildung katalytischen Kokses auf dieser man nacheinander diese Wand überzieht
- mit wenigstens einer Zwischenschicht, gebildet aus einer Zusammensetzung, die gewählt ist aus der Gruppe, welche durch Titancarbid TiC, Titannitrid TiN, Aluminiumnitrid, die Nitride der allgemeinen Formel TiᵤAlᵥN_{w}gebildet ist, in der u, v und w positive Zahlen sind und die Carbonnitride des Titans der allgemeinen Formel TiₓC_{y}N_{z}, in der x, y, z die positiven Zahlen sind und die über einen Ausdehnungskoeffizienten von 4 x 10⁻⁶ bis etwa 12 x 10⁻⁶ °K⁻¹ verfügt, wobei die Schicht (oder diese Zwischenschicht(en)) eine Dicke von etwa 0,1 x 10⁻⁶ bis etwa 30 x 10⁻⁶ m haben und aus der chemischen Abscheidung in der Dampfphase wenigstens einer Verbindung eines Metalls oder eines geeigneten Nichtmetalls bei einer Temperatur größer oder gleich etwa 800°C und unter einem Molfluss von etwa 1 x 10⁻⁶ bis etwa 13⁻² Mol pro cm² und Sekunde resultiert bzw. resultieren,
- und durch eine äußere Schicht, gebildet aus einer Verbindung vom stoechiometrischen Typ oder gebildet durch wenigstens eine feste Lösung, die gebildet ist ausgehend vom Si-Al-O-N-C System und über einen Ausdehnungskoeffizienten von etwa 2 x 10⁻⁶ bis etwa 10 x 10⁻⁶ °K⁻¹ verfügt, wobei diese Außenschicht über eine Dicke von etwa 0,1 x 10⁻⁶ bis etwa 30 x 10⁻⁶ m verfügt und aus der chemischen Abscheidung in der Dampfphase wenigstens einer Verbindung des Siliciums bei einer Temperatur größer oder gleich 800°C und unter einem Molstrom von etwa 1 x 10⁻⁶ bis etwa 10⁻² Mol pro cm² und Sekunde resultiert, wobei das Verfahren im übrigen derart ist, dass, zum Erhalt von Schichten mit im wesentlichen gleichförmigen Dicken man die Vorgänge des Überziehens unter einem Druck von 1 000 bis 10 000 Pascal vornimmt.

2. Verfahren nach Anspruch 1, bei dem die durch chemische Abscheidung in der Dampfphase erhaltenen Zwischenschichten entweder von stoechiometrischer Zusammensetzung oder Feststofflösungen sind.

3. Verfahren nach einem der Ansprüche 1 und 2, bei dem man eine Superlegierung überzieht, die in ihrer Zusammensetzung wenigstens 0,1 Gew.-% Kohlenstoff umfasst, und die erste durch chemische Abscheidung in der Dampfphase direkt auf der Überlegierung erhaltene Überzugsschicht wenigstens eine stoechiometrische Verbindung oder wenigstens eine Feststofflösung umfasst, die in der aus TiC und TiₓC_{y}N_{z} gebildeten Gruppe gewählt ist.

4. Verfahren nach einem der Ansprüche 1 bis 3, bei dem die äußere Schicht des Überzugs auf der Basis von Siliciumcarbid, Siliciumnitrid oder deren Gemisch beruht.

5. Verfahren nach einem der Ansprüche 1 bis 4, bei dem man die Innenwand durch wenigstens eine Zwischenschicht aus Titancarbid TiC, dann durch eine Schicht aus Siliciumcarbid SiC überzieht.

6. Verfahren nach einem der Ansprüche 1 bis 5, dadurch gekennzeichnet, dass es ex situ vor der Montage des Rohrbündels in dem Dampfcrackofen durchgeführt wird.

7. Verfahren nach einem der Ansprüche 1 bis 5, dadurch gekennzeichnet, daß es in situ nach Montage des Rohrbündels im Dampfcrackofen durchgeführt wird.

8. Rohr für Dampfcrackofen, dessen Innenwand gebildet wird aus einer Superlegierung auf der Basis von Nickel und Eisen, die weniger als 3 Gew.-% Aluminium enthält und einen Passivierungs- und/oder Inhibierungsüberzug der Bildung katalytischen Kokses, erhalten nach einem Verfahren der Ansprüche 1 bis 7, umfasst.

9. Rohr nach Anspruch 8, dessen Innenwand mit einer Zwischenschicht aus Titancarbid TiC und einer Siliciumcarbidschicht SiC überzogen ist.

## Claims

1. A method for caoting at least the internal wall of furnace tubes for hydrocarbon steam-cracking, made of a nickel and iron-based superalloy containing less than 3 % by weight of aluminium and having an expansion coefficient of about 10 x 10⁻⁶ to about 25 x 10⁻⁶ °K⁻¹, wherein, in order to effect the passivation of said wall and/or inhibit the formation of catalytic coke theron, said wall is successively coated
- with at least one intermediate layer formed of a compound selected from the group formed by titanium carbide TiC, titanium nitride TiN, aluminium nitride, nitrides with general formula TIᵤAIᵥN_{w}, where u, v and w are positive numbers, and carbonitrides of titanium with general formula TiₓC_{y}N_{z}, where x, y and z are positive numbers, and having an expansion coefficient of about 4 x 10⁻⁶ to about 12 x 10⁻⁶ °K⁻¹, said intermediate layer(s) having a thickness of from about 0.1 x 10⁻⁶ to about 30 x 10⁻⁶ m and resulting from the chemical vapour deposition of at least one compound of a suitable metal or metalloid, at a temperature equal to or higher than about 800°C and under a mole flow rate of about 1 x 10⁻⁶ to about 10⁻² molar per cm² and per second,
- and with an external layer formed of at least one stoichiometric type compound or formed by at least one solid solution formed from the Si-AI-0-N-C system, and having an expansion coefficient of about 2 x 10⁻⁶ to about 10 x 10⁻⁶ °K⁻¹, said external layer having a thickness of about 0.1 x 10⁻⁶ to about 30 x 10⁻⁶ and resulting from chemical vapour deposition of at least one silicon compound, at a temperature equal to or higher than 800°C and under a molar flow rate of about 1 x 10⁻⁶ to about 10⁻² mole per cm² and per second,
said method further being such that, in order to obtain layers of substantially uniform thickness, the coating steps are carried out under a pressure of from 1000 to 10,000 Pascals.

2. A method according to claim 1, in which the intermediate layers obtained by chemical vapour deposition either have a stoichiometric composition or are solid solutions.

3. A method according to any one of claims 1 and 2, in which the superalloy to be coated contains at least 0.1% by weight of carbon and the first coating layer obtained by chemical vapour deposition, in direct contact with the superalloy comprises at least one stoichiometric compound or at least one solid solution selected from the group formed by TiC and TiₓC_{y}N_{z}.

4. A method according to any one of claims 1 to 3, in which the external layer of the coating is a silicon carbide or silicon nitride based coating, or a mixture thereof.

5. A method according to any one of claims 1 to 4, in which said internal wall is being coated with at least one intermediate layer of titanium, carbide TiC then wich a layer of silicon carbide SiC.

6. A method according to any one of claims 1 to 5, characterised in that it is carried out ex-situ before assembly of the pipework in the steam-cracking furnace.

7. A method according to any one of claims 1 to 5, characterised in that it is carried out in-situ after assembly of the pipework in the steam-cracking furnace.

8. A furnace tube for steam cracking the internal wall of which is made of a nickel and iron based superalloy containing less than 3% by weight of aluminium and including a coating for passivation and/or inhibition of formation of catalytic coke, obtained by a method according any one of claims 1 to 7.

9. A tube according to claim 8 the internal wall of which is coated with an intermediate layer of titanium carbide TiC and a layer of silicon carbide SiC.
